(19) Europäisches Patentamt
European Patent Office
Office européen des brevets

(11) **EP 3 913 382 B1**

(12) **EUROPÄISCHE PATENTSCHRIFT**

(45) Veröffentlichungstag und Bekanntmachung des Hinweises auf die Patenterteilung:
**08.05.2024  Patentblatt 2024/19**

(21) Anmeldenummer: **20175305.0**

(22) Anmeldetag: **19.05.2020**

(51) Internationale Patentklassifikation (IPC):
**G01R 31/08** (2020.01)

(52) Gemeinsame Patentklassifikation (CPC):
**G01R 31/085;** G01R 31/088; Y04S 10/52

(54) **VERFAHREN UND EINRICHTUNG ZUM ERMITTELN DES FEHLERORTES EINES DREIPOLIGEN UNSYMMETRISCHEN FEHLERS AUF EINER LEITUNG EINES DREIPHASIGEN ELEKTRISCHEN ENERGIEVERSORGUNGSNETZES**

METHOD AND DEVICE FOR DETERMINING THE LOCATION OF A THREE-POLE ASSYMETRICAL FAULT ON A LINE OF A THREE-PHASE ELECTRICAL ENERGY SUPPLY NETWORK

PROCÉDÉ ET DISPOSITIF DE DÉTERMINATION DE LA LOCALISATION D'UN DÉFAUT NON SYMÉTRIQUE À TROIS PÔLES SUR UNE LIGNE D'UN RÉSEAU D'ALIMENTATION ÉLECTRIQUE TRIPHASÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**24.11.2021  Patentblatt 2021/47**

(73) Patentinhaber: **Siemens Aktiengesellschaft 80333 München (DE)**

(72) Erfinder: **Horak, Martin 85101 Bratislava (SK)**

(74) Vertreter: **Siemens Patent Attorneys Postfach 22 16 34 80506 München (DE)**

(56) Entgegenhaltungen:
EP-A1- 3 088 906        CN-A- 104 820 169
CN-A- 109 581 116       US-A1- 2012 086 459
US-A1- 2014 336 959

- **DAS SWAGATA ET AL: "Impedance-Based Fault Location in Transmission Networks: Theory and Application", IEEE ACCESS, Bd. 2, 29. Mai 2014 (2014-05-29), Seiten 537-557, XP011549977, DOI: 10.1109/ACCESS.2014.2323353 [gefunden am 2014-06-02]**
- **MEGHWANI ANJU ET AL: "An on-line fault location technique for DC microgrid using transient measurements", 2017 7TH INTERNATIONAL CONFERENCE ON POWER SYSTEMS (ICPS), IEEE, 21. Dezember 2017 (2017-12-21), Seiten 386-391, XP033359381, DOI: 10.1109/ICPES.2017.8387325 [gefunden am 2018-06-15]**

**Beschreibung**

Die Erfindung betrifft ein Verfahren zum Ermitteln des Fehlerortes eines unsymmetrischen dreipoligen Fehlers auf einer Leitung eines dreiphasigen elektrischen Energieversorgungsnetzes. Die Erfindung betrifft auch eine entsprechende Einrichtung zur Durchführung des Verfahrens.

Der sichere Betrieb elektrischer Energieversorgungsnetze erfordert die schnelle und zuverlässige Erkennung und Abschaltung etwaiger Fehler, wie z.B. von Kurzschlüssen oder Erdschlüssen. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein.

Für die Klärung eines solchen Fehlers auf einer Leitung sind diverse Schutzfunktionen zuständig. In den überwiegenden Fällen reicht es, die elektrische Energiezufuhr durch Öffnen eines Schalters für kurze Zeit zu unterbrechen und somit ein Erlöschen eines während des Fehlers brennenden Lichtbogens zu erzwingen. Ist dieser Prozess erfolgreich, kann das Energieversorgungsnetz ohne Weiteres weiter betrieben werden. Der Fehler kann aber Beschädigungen an den Leitungen verursachen.

Zur Erkennung solcher Beschädigungen und zur Verkürzung von fehlerbedingten Ausfallzeiten müssen aufgetretene Fehler möglichst genau lokalisiert werden, um eine Behebung der Fehlerursache und etwaiger durch den Fehler herbeigeführter Folgeschäden durch ein Wartungsteam zu ermöglichen.

Im einfachsten, aber auch aufwendigsten, Fall findet eine Fehlerortung durch Inaugenscheinnahme statt. Dabei fährt das Wartungsteam die fehlerhafte Leitung ab und untersucht sie auf sichtbare Fehlerstellen. Diese Vorgehensweise ist langsam und fehleranfällig.

Daher ist man weitgehend dazu übergegangen, den Fehlerort, an dem sich der Fehler auf der Leitung befindet, mittels einer Analyse von während des Fehlereintritts erfassten Messgrößen, z.B. Strömen und Spannungen, einzugrenzen. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert daraufgelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Ein grobes Ergebnis des Fehlerortes lässt sich beispielsweise durch die Feststellung der Fehlerrichtung erreichen. Diese Methode wird überwiegend in gelöschten, isolierten sowie hochohmig geerdeten Energieversorgungsnetzen mit einer radialen Struktur bzw. einem geringen Vermaschungsgrad eingesetzt. Dabei kann beispielsweise eine wattmetrische Methode verwendet werden, wie sie aus dem Europäischen Patent EP 2476002 B1 bekannt ist. Eine andere Methode zur Erkennung der Fehlerrichtung ist das sogenannte "Wischerrelais-Prinzip", das in einer möglichen ausführungsform beispielsweise aus der internationalen Patentanmeldung WO 2012126526 A1 hervorgeht. Zur genaueren Fehlerortung ist bei diesen Methoden allerdings eine zusätzliche Auswertung nötig. US 2012/086459 A1 und "Impedance-Based Fault Location in Transmission Networks: Theory and Application", DAS SWAGATA ET AL, IEEE ACCESS, Bd. 2, 29. Mai 2014, Seiten 537-557, offenbaren relevante Fehlerortungsansätze aus dem Stand der Technik.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben.

Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4996624 A entnommen werden.

Eine verbesserte Genauigkeit bei der Fehlerortung ließe sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit bei der Fehlerortung erreicht. Zweiseitige Ortungsverfahren sind jedoch vergleichsweise aufwendig, da hier eine Kommunikationsverbindung vorliegen muss und die Messwerte von beiden Leitungsenden miteinander zeitlich synchronisiert werden müssen, so dass in vielen Fällen weiterhin einseitige Fehlerortungsverfahren eingesetzt werden.

Voraussetzung einer erfolgreichen Fehlerortung ist auch die Erkennung, welche Schleife der Leitung vom Fehler betroffen ist. Prinzipiell können verschiedene mögliche Fehlerschleifen vorliegen:

Phase 1 - Erde;

Phase 2 - Erde;

Phase 3 - Erde;

Phase 1 - Phase 2 (mit und ohne Erdbeteiligung);

Phase 2 - Phase 3 (mit und ohne Erdbeteiligung);

Phase 3 - Phase 1 (mit und ohne Erdbeteiligung);

Phase 1 - Phase 2 - Phase 3 (mit und ohne Erdbeteiligung).

Während ein- und zweipolige Fehler einen unsymmetrischen Fehler bilden, liegt bei einem dreipoligen Fehler üblicherweise ein symmetrischer Fehler vor, bei dem grundsätzlich 3 messbare Phase-Phase-Schleifen gebildet werden, für die jeweils eine Impedanz berechnet werden kann. Da die Impedanzen annähernd übereinstimmen, lässt sich das genaue Fehlerortungsergebnis hierbei aus dem Mittelwert der gemessenen Impedanzen ermitteln.

Im selteneren Falle eines dreipoligen unsymmetrischen Fehlers, bei dem mindestens eine der Phasen einen von den übrigen Phasen abweichenden Fehlerwiderstand aufweist, bilden sich sechs voneinander abweichenden Fehlerimpedanzen, die die Ermittlung des korrekten Fehlerortes erschweren und oft zum Misserfolg bei der Fehlersuche führen. Für diesen Fall muss das impedanzbasierte Verfahren nach anderem Berechnungsprinzip arbeiten.

Aufgrund ihrer vermeintlichen Seltenheit wurde die Problematik der Fehlerortung von dreipoligen unsymmetrischen Fehlern bisher nicht detailliert untersucht. Tatsächlich tritt diese Fehlerart auf Übertragungsnetzebene (>110kV) eher selten auf und wird in den meisten Fällen durch eine mechanische Störung hervorgerufen. Durch die steigende Automatisierung auf Verteilungsebene mit niedrigeren Spannungslevels (< 110kV) und dadurch bedingten Einsatz von Überwachungs- und Schutzsystemen auf dieser Spannungsebene konnte hingegen erkannt werden, dass temporäre dreipolige unsymmetrische Fehler im Verteilnetz durchaus keine Seltsamkeit darstellen. Ein Grund dafür ist der physikalische Aufbau von Masten sowie die begrenzte Möglichkeit des Netzbetreibers bei der Pflege der vergleichsweise langen Übertragungsstrecken.

Der Erfindung liegt daher die Aufgabe zugrunde, eine Fehlerortung auch bei dreipoligen unsymmetrischen Fehlern mit hoher Genauigkeit durchführen zu können.

Diese Aufgabe wird erfindungsgemäß durch ein Verfahren gemäß Anspruch 1 gelöst.

Die Erfindung beruht auf der Erkenntnis, dass bei einem unsymmetrischen Fehler die Abweichungen bei der Bestimmung der phasenbezogenen Impedanzen aus unterschiedlichen Fehlerwiderständen herrühren. Um dies zu berücksichtigen, wird eine Fehlerortung auf Basis der Reaktanz durchgeführt, wodurch der üblicherweise resistive Anteil des Fehlerwiderstandes eliminiert wird.

Um die Unsymmetrie der Fehlerwiderstände in der Ermittlung des Fehlerortes zu berücksichtigen, ist gemäß einer vorteilhaften Ausführungsform des erfindungsgemäßen Verfahrens vorgesehen, dass der individuelle Fehlerwiderstand durch Verwendung einer Spannungs-Korrekturgröße bei der Bestimmung der Reaktanz berücksichtigt wird.

Konkret kann in diesem Zusammenhang auf der einen Seite vorgesehen sein, dass die Strom- und Spannungswerte für die drei Leiter-Erde-Schleifen (Phase 1 - Erde; Phase 2 - Erde; Phase 3 - Erde) verwendet werden und als Spannungs-Korrekturgröße eine Spannung zwischen dem Sternpunkt des Fehlers und Erde verwendet wird.

Auf der anderen Seite kann die Berücksichtigung des Fehlerwiderstandes auch dadurch erfolgen, dass die Strom- und Spannungswerte für die drei Leiter-Leiter-Schleifen (Phase 1 - Phase 2; Phase 2 - Phase 3; Phase 3 - Phase 1) verwendet werden und als Spannungs-Korrekturgröße eine Spannung von einer der Phasen zwischen der Messstelle und dem Sternpunkt des Fehlers verwendet wird.

In beiden Ausführungsvarianten wird eine entsprechend der gewählten Fehlerschleifen angepasste Spannungs-Korrekturgröße verwendet, um die durch die unterschiedlichen Fehlerwiderstände hervorgerufene Unsymmetrie zu berücksichtigen und einen genauen Fehlerort zu bestimmen.

Gemäß einer weiteren vorteilhaften Ausführungsform des erfindungsgemäßen Verfahrens kann vorgesehen sein, dass die Fehlerortbestimmung nur dann durchgeführt wird, wenn nach Eintritt des Fehlers erkannt wird, dass der Fehler ein unsymmetrischer dreipoliger Fehler ist.

Hierdurch kann eine an die jeweilige Fehlerart angepasste Art der Fehlerortbestimmung durchgeführt werden. Bei unsymmetrischen ein- bzw. zweipoligen sowie bei symmetrischen dreipoligen Fehlern wird dann eine andere Art der Fehlerortbestimmung durchgeführt.

In einem Spezialfall kann das beschriebene Verfahren auch zur Bestimmung des Fehlerortes von unsymmetrischen zweipoligen Fehlern eingesetzt werden. Dabei wird solch ein Fehler rechnerisch in einen dreipoligen Fehler umgewandelt, wobei als Annahme verwendet wird, dass zwischen zwei Phasen ein unendlicher Fehlerwiderstand vorliegt.

Die fehlerbehaftete Schleife kann dabei beispielsweise anhand des Vorliegens verschiedener Kriterien erkannt werden. Beispielsweise kann anhand von Auffälligkeiten bei Strom- und Spannungswerten der einzelnen Phasen eine Entscheidung getroffen werden, welche Schleife von einem Fehler betroffen ist. Besonders vorteilhaft kann die Erkennung der fehlerbehafteten Schleife durch gleichzeitige Prüfung verschiedener Kriterien erfolgen, wie es beispielsweise in der internationalen Patentanmeldung WO 2016091334 A1 der Anmelderin beschrieben ist. Eine Entscheidung, ob ein symmetrischer oder ein unsymmetrischer dreipoliger Fehler vorliegt, kann in diesem Zusammenhang beispielsweise dadurch getroffen werden, dass die Auswertung der verschiedenen Kriterien generell für alle drei Phasen einen Fehler anzeigt, jedoch die Intensität der Kriterienerfüllung für alle drei Phasen unterschiedlich ist. Beispielsweise könnte bei einem Kriterium "Stromhöhe" zwar für alle drei Phasen eine Überschreitung eines Stromschwellenwertes vorliegen, sie könnte jedoch bei allen Phasen etwas unterschiedlich ausfallen, so dass ein unsymmetrischer Fehler erkannt wird. Bei nahezu gleichen Strömen wird hingegen ein symmetrischer Fehler erkannt.

Die oben genannte Aufgabe wird auch durch eine Einrichtung gemäß Anspruch 5 gelöst.

Hierbei kann die Einrichtung vorteilhaft durch ein elektrisches Schutzgerät gebildet sein, das neben der Fehlerortung noch weitere Schutz- und Überwachungsfunktionen für das elektrische Energieversorgungsnetz (z.B. eine Distanzschutzfunktion für die Leitung) durchführt. Alternativ dazu kann jedoch auch vorgesehen sein, dass die Einrichtung eine separate Fehlerlokalisier-Einrichtung ist.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen

Figur 1 eine schematische Ansicht einer Leitung eines Energieversorgungsnetzes mit einer Einrichtung zur Ermittlung eines Fehlerortes;

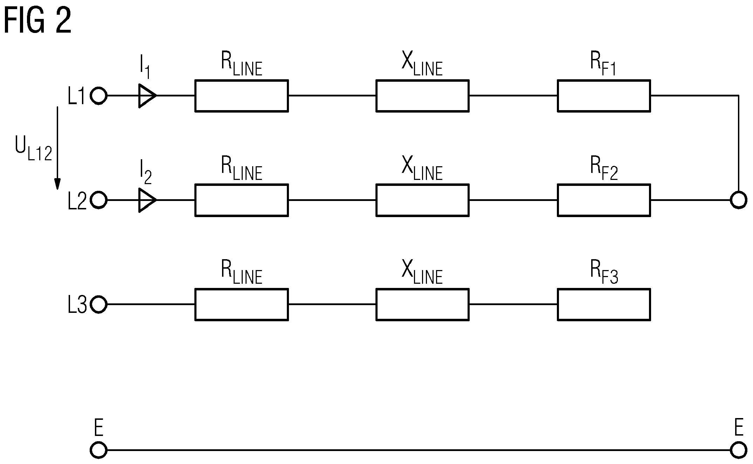

Figur 2 eine schematische Darstellung eines zweipoligen Fehlers an einer Leitung;

Figur 3 ein erstes Beispiel einer Darstellung eines dreipoligen unsymmetrischen Fehlers an einer Leitung;

Figur 4 ein zweites Beispiel einer Darstellung eines dreipoligen unsymmetrischen Fehlers an einer Leitung; und

Figur 5 ein schematisches Ablaufdiagramm eines Verfahrens zum Ermitteln des Fehlerortes eines dreipoligen unsymmetrischen Fehlers.

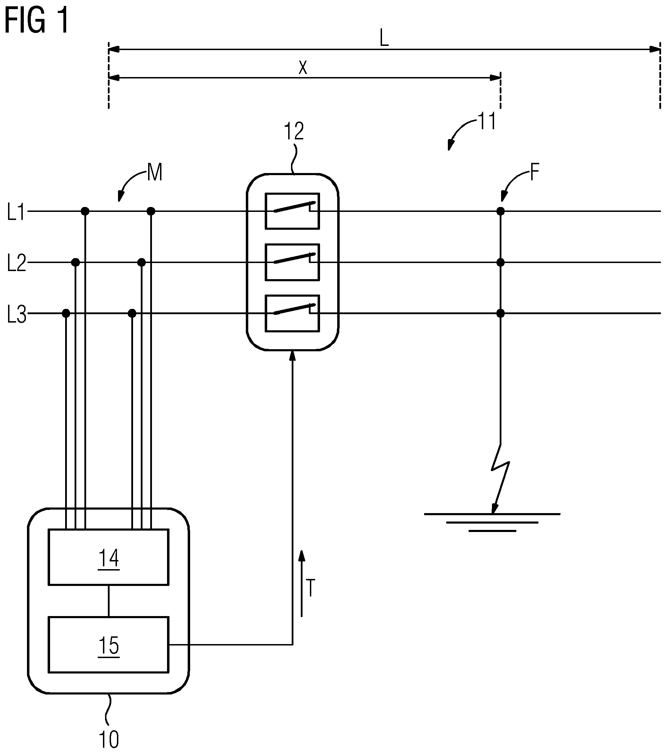

Figur 1 zeigt eine schematische Ansicht einer Einrichtung 10 zum Ermitteln eines Fehlerortes in einem elektrischen Energieversorgungsnetz. Hierzu ist in Figur 1 eine dreiphasige elektrische Leitung 11 des Energieversorgungsnetzes in vereinfachter Darstellung gezeigt. Die Leitung habe die Länge L.

Die Leitung 11 wird an ihrem einen Leitungsende durch einen dreipoligen Leistungsschalter 12 begrenzt und kann durch diesen, insbesondere im Fehlerfall, vom restlichen, in Figur 1 nicht näher dargestellten Energieversorgungsnetz abgetrennt werden. Am Leitungsende ist zudem eine Messstelle M vorgesehen, an denen mit in Figur 1 lediglich angedeuteten Stromwandlern und Spannungswandlern Strom- und Spannungsmesswerte erfasst werden. Bei den Stromwandlern und den Spannungswandlern kann es sich um konventionelle oder nicht konventionelle Wandler (z.B. Rogowski-Spule) handeln. Sekundärseitig werden von den Wandlern für jede Phase der Leitung 11 Strommesswerte und Spannungsmesswerte abgegeben, bei denen es sich um analoge oder digitalisierte Werte handeln kann.

Mit den Stromwandlern und den Spannungswandlern steht die Einrichtung 10 zur Ermittlung eines Fehlerortes in Verbindung. Bei der Einrichtung 10 kann es sich beispielsweise um ein elektrisches Schutzgerät handeln, das neben einer Fehlerortungsfunktion auch weitere Schutz- und Überwachungsfunktionen durchführt. Beispielsweise kann es sich bei dem Schutzgerät um ein Distanzschutzgerät handeln, das den Betriebszustand der Leitung 11 anhand der erfassten Strom- und Spannungsmesswerte überwacht und im Fehlerfall ein Ausschaltsignal T an den Leistungsschalter 12 übermittelt, um diesen zum Öffnen seiner Schaltkontakte zu veranlassen.

Zu diesem Zweck weist die Einrichtung 10 eine Messvorrichtung 14 sowie eine Auswerteinheit 15 auf. Mit der Messvorrichtung 14 erfasst die Einrichtung 10 die Strom- und Spannungsmesswerte und führt ggf. eine Digitalisierung und/oder eine Vorverarbeitung durch. Die erfassten und ggf. vorverarbeiteten Strom- und Spannungswerte werden daraufhin der Auswerteinheit 15 zugeführt. Die Auswerteinheit 15 ist dazu eingerichtet, im Fehlerfall auf der Leitung 11 den Fehlerort, also denjenigen Ort auf der Leitung, an dem ein Fehler (z.B. Kurzschluss, Erdschluss) aufgetreten ist, zu ermitteln und auszugeben. Hierzu verwendet sie die Strom- und/oder Spannungswerte, die vor und während des Fehlers erfasst worden sind.

Die Einrichtung 10 kann eine Fehlerortung für beliebige Fehlerarten durchführen. Insbesondere ist die Einrichtung 10 jedoch dazu eingerichtet, den Fehlerort eines dreipoligen unsymmetrischen Fehlers anzugeben. In Figur 1 ist beispielhaft ein solcher Fehler eingezeichnet. Hierbei wird angenommen, dass an einem Fehlerort F ein Fehler aufgetreten sei. Von der Messstelle M aus gesehen liegt der Fehlerort F in einer Entfernung x. Die Einrichtung wertet wie nachfolgend im Einzelnen beschrieben die Strom- und Spannungswerte aus und gibt den Fehlerort F, beispielsweise als Entfernung x oder Prozent der Leitungslänge L an. Der Betreiber des Energieversorgungsnetzes kann den ermittelten Fehlerort F an ein Wartungsteam weitergeben, das daraufhin den Fehlerort aufsuchen und die Fehlerursache beheben kann. Hierzu ist eine möglichst genaue Ermittlung des Fehlerortes erforderlich. Nachfolgend wird eine Vorgehensweise zur genauen Fehlerortung beschrieben.

Zum besseren Verständnis der vorgeschlagenen Methode werden zuerst die Verhältnisse bei einem unsymmetrischen zweipoligen Fehler ohne Erdbeteiligung betrachtet. Ein solcher Fehlerfall ist in Figur 1 beispielhaft für einen Fehler zwischen den Phasen L1 und L2 dargestellt. Für die Kurzschlussspannung $\underline{U}_{L12}$ zwischen den beiden Phasen L1 und L2 gilt folgende Beziehung:

$$\underline{U}_{L12} = j\underline{X}_{Line} \cdot \underline{I}_1 + R_{Line} \cdot I_1 + R_{F1} \cdot \underline{I}_1 - j\underline{X}_{Line} \cdot \underline{I}_2 - R_{Line} \cdot I_2 - R_{F2} \cdot \underline{I}_2 \qquad (1)$$

wobei $\underline{I}_1$ und $\underline{I}_2$ die in den Phasen L1 und L2 fließenden Kurzschlussströme sind. Die Kurzschlussentfernung x wird von der Kurzschlussimpedanz $\underline{Z}_{Line} = R_{Line} + j\underline{X}_{Line}$ definiert. Der Lichtbogen wird durch die Kurzschlusswiderstände $R_{F1}$ und $R_{F2}$ abgebildet. Da in diesem Fall gilt:

$$\underline{I}_1 = -\underline{I}_2,$$

kann zum Zwecke der Fehlerortung Gleichung (1) in einer vereinfachten Form dargestellt werden:

$$\underline{Z}_{L12} = \underline{Z}_{Line} + \frac{R_{F1}}{2} + \frac{R_{F2}}{2} \qquad (2)$$

Zur Eliminierung der Fehlerwiderstände $R_{F1}$ und $R_{F2}$ betrachtet man nur die Reaktanz der Kurzschlussimpedanz. Damit kann die Leitungsreaktanz $\underline{X}_{Line}$ und damit im Verhältnis zur Gesamtreaktanz der Leitung $\underline{X}_{ges}$ mit der Länge L das eindeutige Ergebnis der Fehlerortung ermittelt werden:

$$x = \frac{\underline{X}_{Line}}{\underline{X}_{ges}} \cdot L$$

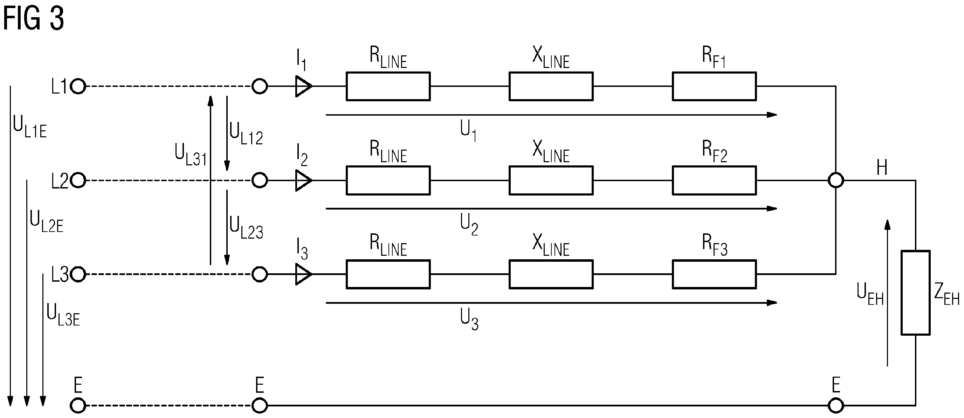

Handelt sich jedoch um einen unsymmetrischen dreipoligen Fehler mit unterschiedlichen Fehlerwiderständen $R_{F1}$, $R_{F2}$, $R_{F3}$, sind die Ströme $\underline{I}_1$, $\underline{I}_2$, $\underline{I}_3$ unterschiedlich. Dieser Fall ist in Figur 3 dargestellt.

Für diesen Fall gilt die obige Gleichung (2) folglich nicht mehr und muss entsprechend angepasst werden. Damit gilt für die Kurzschlussspannung $\underline{U}_{L12}$ zwischen den Phasen L1 und L2:

$$\frac{\underline{U}_{L12}}{(\underline{I}_1 - \underline{I}_2)} = \underline{Z}_{Line} + \frac{[R_{F1} \cdot \underline{I}_1 - (R_{F1} + \Delta R) \cdot \underline{I}_2]}{(\underline{I}_1 - \underline{I}_2)} \qquad (3)$$

wobei ΔR stellt die Differenz zwischen den beiden Fehlerwiderstände $R_{F1}$ und $R_{F2}$ der fehlerbeteiligten Phasen darstellt. Nach entsprechender Umformulierung kann Gleichung (3) folgendermaßen geschrieben werden:

$$\underline{Z}_{L12} = \underline{Z}_{Line} + R_{F1} - \Delta R \frac{\underline{I}_2}{(\underline{I}_1 - \underline{I}_2)} \qquad (4)$$

Aus Gleichung 4 ergibt sich, dass bei einer zwischen den Phasenströmen auftretenden Winkeldifferenz auftritt und zusätzlich ungleichen Fehlerwiderständen $R_{F1}$, $R_{F2}$ ein zusätzlicher Anteil als eine fiktive Reaktanz entsteht und das Ergebnis der Fehlerortung verfälscht. Das Ziel des neuen Verfahrens ist es, den angesprochenen Einfluss zu reduzieren.

Zur Lösung dieses Problems müssen entweder alle drei Phase-Erde-Schleifen oder alle drei Phase-Phase-Schleifen in einem Berechnungsalgorithmus berücksichtigt werden. Nach Eliminierung der Fehlerwiderstände ist deren Einfluss durch eine Spannungs-Korrekturgröße zu berücksichtigen.

Basierend auf der Darstellung der Figur 3 kann für die Phase-Erde-Schleifen folgendes Gleichungssystem formuliert werden:

$$\underline{U}_{L1E} = \left(\underline{Z}_{Line} + R_{F1}\right) \cdot \underline{I}_1 + \underline{U}_{EH}$$

$$\underline{U}_{L2E} = \left(\underline{Z}_{Line} + R_{F2}\right) \cdot \underline{I}_2 + \underline{U}_{EH}$$

$$\underline{U}_{L3E} = \left(\underline{Z}_{Line} + R_{F3}\right) \cdot \underline{I}_3 + \underline{U}_{EH}$$

wobei die Spannungs-Korrekturgröße $\underline{U}_{EH}$ eine unbekannte Spannung am Sternpunkt des Fehlers darstellt. Zur vereinfachten Darstellung wird ein Kehrwert vom jeweiligen gemessenen Strom

$$\underline{m}_i = \frac{1}{\underline{I}_i}$$

eingeführt und jede Gleichung des Gleichungssystems mit diesem Wert beidseitig multipliziert. Jede der Gleichungen kann dann in folgender Form geschrieben werden:

$$\underline{U}_{LiE} \cdot \underline{m}_i = \underline{Z}_{Line} + R_{Fi} + \underline{U}_{EH} \cdot \underline{m}_i$$

Dabei sind die Werte für $\underline{U}_{Li}$ und $\underline{m}_i$ durch Messung bekannt. Zur Eliminierung des Fehlerwiderstandes $R_{Fi}$ dürfen nur die imaginären Anteile der Gleichungen berücksichtigt werden:

$$Im\{\underline{U}_{LiE} \cdot \underline{m}_i\} = \underline{X}_{Line} + Im\{\underline{m}_i\} \cdot Re\{\underline{U}_{EH}\} + Re\{\underline{m}_i\} \cdot Im\{\underline{U}_{EH}\}$$

In diesem Gleichungssystem stellen die gesuchte Reaktanz $\underline{X}_{Line}$ sowie die Größen $Re\{\underline{U}_{EH}\}$ und $Im\{\underline{U}_{EH}\}$ drei Unbekannte dar. Das Gleichungssystem kann somit wie folgt formuliert werden:

$$\begin{bmatrix} Im\{\underline{U}_{L1E} \cdot \underline{m}_1\} \\ Im\{\underline{U}_{L2E} \cdot \underline{m}_2\} \\ Im\{\underline{U}_{L3E} \cdot \underline{m}_3\} \end{bmatrix} = \begin{bmatrix} 1 & Im\{\underline{m}_1\} & Re\{\underline{m}_1\} \\ 1 & Im\{\underline{m}_2\} & Re\{\underline{m}_2\} \\ 1 & Im\{\underline{m}_3\} & Re\{\underline{m}_3\} \end{bmatrix} \cdot \begin{bmatrix} \underline{X}_{Line} \\ Re\{\underline{U}_{EH}\} \\ Im\{\underline{U}_{EH}\} \end{bmatrix}$$

Die Lösung dieser Gleichungen führt zum Ergebnis in Form der gesuchten Kurzschlussreaktanz $X_{Line}$ und damit zur Bestimmung des Fehlerortes x.

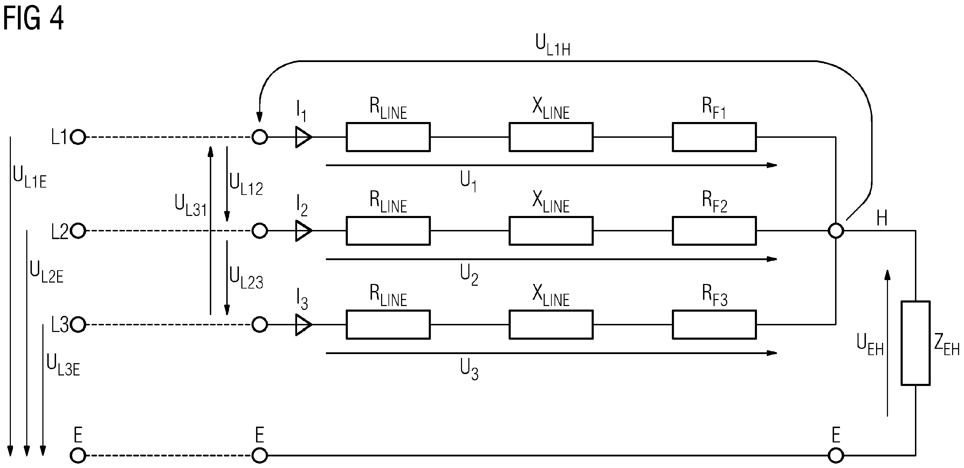

Alternativ dazu kann basierend auf der Darstellung der Figur 4 kann für die Phase-Phase-Schleifen ein anderes Gleichungssystem formuliert werden:

$$\underline{U}_{L1H} = \underline{Z}_{Line} \cdot \underline{I}_1 + R_{F1} \cdot \underline{I}_1$$

$$\underline{U}_{L1H} = \underline{U}_{L12} + \left(\underline{Z}_{Line} + R_{F2}\right) \cdot \underline{I}_2$$

$$\underline{U}_{L1H} = \underline{U}_{L31} + \left(\underline{Z}_{Line} + R_{F3}\right) \cdot \underline{I}_3$$

wobei die Spannungs-Korrekturgröße $\underline{U}_{L1H}$ eine unbekannte Spannung an Phase L1 zwischen der Messstelle und dem Sternpunkt des Fehlers darstellt. Zur vereinfachten Darstellung wird auch hier ein Kehrwert vom jeweiligen gemessenen

Strom

$$\underline{m}_i = \frac{1}{\underline{I}_i}$$

eingeführt und jede Gleichung des Gleichungssystems mit diesem Wert beidseitig multipliziert. Nach einigen Umformungen erhält man folgendes Gleichungssystem:

$$\begin{bmatrix} 0 \\ -Im\{\underline{U}_{L12} \cdot \underline{m}_2\} \\ -Im\{\underline{U}_{L31} \cdot \underline{m}_3\} \end{bmatrix} = \begin{bmatrix} 1 & Im\{\underline{m}_1\} & Re\{\underline{m}_1\} \\ 1 & Im\{\underline{m}_2\} & Re\{\underline{m}_2\} \\ 1 & Im\{\underline{m}_3\} & Re\{\underline{m}_3\} \end{bmatrix} \cdot \begin{bmatrix} \underline{X}_{Line} \\ -Re\{\underline{U}_{L1H}\} \\ -Im\{\underline{U}_{L1H}\} \end{bmatrix}$$

In diesem Gleichungssystem stellen die gesuchte Reaktanz $X_{Line}$ sowie die Größen $Re\{\underline{U}_{L1H}\}$ und $Im\{\underline{U}_{L1H}\}$ drei Unbekannte dar. Die Lösung dieser Gleichungen führt zum Ergebnis in Form der gesuchten Kurzschlussreaktanz $X_{Line}$ und damit zur Bestimmung des Fehlerortes x.

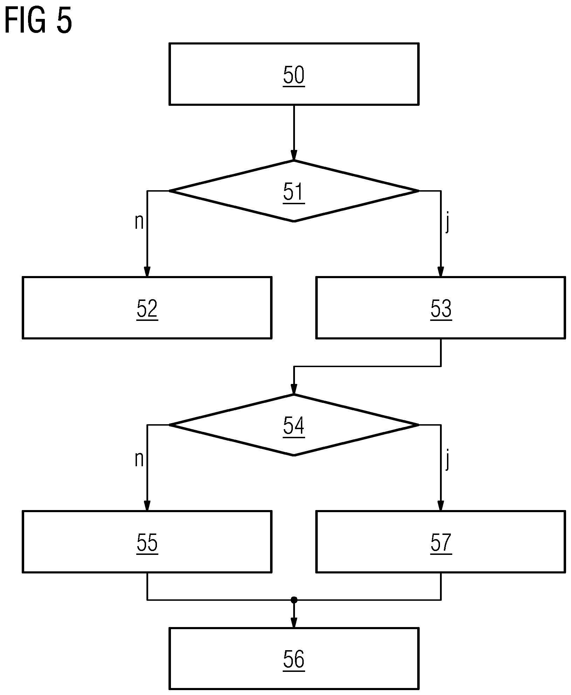

Figur 5 zeigt schließlich ein schematisches Ablaufdiagramm eines Ausführungsbeispiels eines Verfahrens zur Ermittlung des Fehlerortes eines dreipoligen unsymmetrischen Fehlers.

In einem ersten Schritt 50 werden Ströme und Spannungen an den einzelnen Phasen L1, L2, L3 gemessen und der Einrichtung 10 zugeführt. Die Einrichtung prüft auf der einen Seite, ob überhaupt ein Fehler vorliegt. Dazu können gängige Schutzalgorithmen, z.B. ein Distanzschutzalgorithmus oder ein Überstromschutzalgorithmus verwendet werden. Auf der anderen Seite wird in Schritt 51 geprüft, um welche Fehlerart es sich handelt, d.h. welche Schleife von dem Fehler betroffen ist. Konkret wird geprüft, ob es sich um die Fehlerart "dreipoliger unsymmetrischer Fehler" handelt oder um eine andere Fehlerart. Handelt es sich um eine andere Fehlerart, z.B. um einen einpoligen Phase-Erde-Fehler, einen zweipoligen Fehler ohne Erdbeteiligung oder um einen symmetrischen dreipoligen Fehler, wird in Schritt 52 eine passende Methode zur Bestimmung des Fehlerortes ausgewählt und durchgeführt.

Handelt es sich hingegen um einen dreipoligen unsymmetrischen Fehler, wird das Verfahren bei Schritt 53 fortgesetzt, indem die Fehlerortungsmethode für dreipolige unsymmetrische Fehler gestartet wird.

In einem nachfolgenden Schritt 54 werden entweder die drei Phase-Erde-Schleifen oder die drei Phase-Phase-Schleifen zur Fehlerortbestimmung ausgewählt.

Werden die drei Phase-Erde-Schleifen verwendet, so findet in Schritt 55 die Fehlerortbestimmung wie oben beschrieben unter Verwendung der Spannung am Sternpunkt des Fehlers als Spannungs-Korrekturgröße statt. Die auf diese Weise ermittelte Leitungsreaktanz $\underline{X}_{Line}$ wird in Schritt 56 ins Verhältnis zur Reaktanz der gesamten Leitung gesetzt und so der Fehlerort x bestimmt und ausgegeben.

Werden die drei Phase-Phase-Schleifen verwendet, so findet in Schritt 57 die Fehlerortbestimmung wie oben beschrieben unter Verwendung der Spannung einer Phase (z.B. L1) zwischen der Messstelle und dem Sternpunkt des Fehlers als Spannungs-Korrekturgröße statt. Die auf diese Weise ermittelte Leitungsreaktanz $\underline{X}_{Line}$ wird ebenfalls an Schritt 56 übergeben und dort ins Verhältnis zur Reaktanz der gesamten Leitung gesetzt und so der Fehlerort x bestimmt und ausgegeben.

Vorstehend wurde eine Methode beschrieben, wie der Fehlerort eines dreipoligen unsymmetrischen Fehlers bestimmt werden kann. Auch wenn diese Fehlerart im Vergleich zu anderen Fehlerarten seltener auftreten mag, ist die Funktion dennoch für eine vollständige Überwachung einer dreiphasigen Leitung, insbesondere auf der Mittel- und Niederspannungsebene im Verteilnetz, in modernen Schutzgeräten zu implementieren. Das Verfahren kann mit geringem Aufwand in einem bestehenden Schutzgerät implementiert werden. Da alle zu messenden Größen bereits zur Verfügung stehen, ist eine Änderung nur hinsichtlich des Fehlerortungsalgorithmus vorzunehmen. In Bezug auf die benötigte Rechenleistung ist nur eine insignifikante Lasterhöhung zu erwarten, die insbesondere deswegen unkritisch ist, weil sie erst nach Fehlereintritt zur Ortung benötigt wird.

**Patentansprüche**

1.  Verfahren zum Ermitteln des Fehlerortes (F) eines unsymmetrischen dreipoligen Fehlers auf einer Leitung (11) eines dreiphasigen elektrischen Energieversorgungsnetzes, bei dem

    - an einer Messstelle (M) an einem Leitungsende der Leitung (11) Strom- und Spannungswerte der drei Phasen (L1, L2, L3) der Leitung (11) gemessen werden; und

- unter Verwendung der gemessenen Strom- und Spannungswerte nach dem Auftreten eines Fehlers auf der Leitung (11) dessen Fehlerort (F) bestimmt wird; wobei

- unter Verwendung der gemessenen Strom- und Spannungswerte entweder der drei Leiter-Erde-Fehlerschleifen oder der drei Leiter-Leiter-Fehlerschleifen eine Reaktanz des bis zum Fehlerort (F) verlaufenden Abschnitts der Leitung (11) bestimmt wird, wobei der individuelle Fehlerwiderstand der einzelnen Phasen (L1, L2, L3) bei der Bestimmung der Reaktanz berücksichtigt wird, wobei der individuelle Fehlerwiderstand durch Verwendung einer Spannungs-Korrekturgröße bei der Bestimmung der Reaktanz berücksichtigt wird, die entsprechend der gewählten Fehlerschleifen angepasst ist; und

- durch Vergleich der Reaktanz mit der Gesamtreaktanz der Leitung (11) der Fehlerort (F) ermittelt wird.

2. Verfahren nach Anspruch 1,
**dadurch gekennzeichnet, dass**

- bei Verwendung der Strom- und Spannungswerte für die drei Leiter-Erde-Schleifen als Spannungs-Korrekturgröße eine Spannung zwischen dem Sternpunkt des Fehlers und Erde verwendet wird.

3. Verfahren nach Anspruch 1,
**dadurch gekennzeichnet, dass**

- bei Verwendung der Strom- und Spannungswerte für die drei Leiter-Leiter-Schleifen als Spannungs-Korrekturgröße eine Spannung von einer der Phasen zwischen der Messstelle und dem Sternpunkt des Fehlers verwendet wird.

4. Verfahren nach einem der vorangehenden Ansprüche, **dadurch gekennzeichnet, dass**

- die Fehlerortbestimmung nur dann durchgeführt wird, wenn nach Eintritt des Fehlers erkannt wird, dass der Fehler ein unsymmetrischer dreipoliger Fehler ist.

5. Einrichtung (10) zum Ermitteln des Fehlerortes (F) eines unsymmetrischen dreipoligen Fehlers auf einer Leitung (11) eines dreiphasigen elektrischen Energieversorgungsnetzes, wobei

- die Einrichtung (10) eine Messvorrichtung (14) aufweist, die dazu eingerichtet ist, an einer Messstelle (M) an einem Leitungsende der Leitung (11) Strom- und Spannungswerte der drei Phasen (L1, L2, L3) der Leitung (11) zu messen; und wobei

- die Einrichtung (10) eine Auswerteinheit (15) aufweist, die dazu eingerichtet ist, unter Verwendung der gemessenen Strom- und Spannungswerte nach dem Auftreten eines Fehlers auf der Leitung (11) dessen Fehlerort (F) zu bestimmen; wobei

- die Auswerteinheit (15) dazu eingerichtet ist, unter Verwendung der gemessenen Strom- und Spannungswerte entweder der drei Leiter-Erde-Fehlerschleifen oder der drei Leiter-Leiter-Fehlerschleifen eine Reaktanz des bis zum Fehlerort (F) verlaufenden Abschnitts der Leitung (11) zu bestimmen, wobei der individuelle Fehlerwiderstand der einzelnen Phasen (L1, L2, L3) bei der Bestimmung der Reaktanz berücksichtigt wird und wobei der individuelle Fehlerwiderstand durch Verwendung einer Spannungs-Korrekturgröße bei der Bestimmung der Reaktanz berücksichtigt wird, die entsprechend der gewählten Fehlerschleifen angepasst ist, und durch Vergleich der Reaktanz mit der Gesamtreaktanz der Leitung (11) den Fehlerort (F) zu ermitteln.

**Claims**

1. Method for identifying the fault location (F) of an unbalanced three-pole fault on a line (11) of a three-phase electrical energy supply grid, in which

- current and voltage values of the three phases (L1, L2, L3) of the line (11) are measured at a measurement point (M) at a line end of the line (11); and

- following the occurrence of a fault on the line (11), the fault location (F) of said fault is determined using the measured current and voltage values; wherein

- a reactance of the section of the line (11) running to the fault location (F) is determined using the measured current and voltage values either of the three conductor-to-earth fault loops or of the three conductor-to-conductor fault loops, wherein the individual fault resistance of the individual phases (L1, L2, L3) is taken into account when determining the reactance, wherein the individual fault resistance is taken into account when determining the reactance by using a voltage correction variable that is adjusted according to the selected fault loop; and
- the fault location (F) is identified by comparing the reactance with the total reactance of the line (11).

2. Method according to Claim 1,
**characterized in that**

- a voltage between the star point of the fault and earth is used as a voltage correction variable when using the current and voltage values for the three conductor-to-earth loops.

3. Method according to Claim 1,
**characterized in that**

- a voltage from one of the phases between the measurement point and the star point of the fault is used as a voltage correction variable when using the current and voltage values for the three conductor-to-conductor loops.

4. Method according to one of the preceding claims, **characterized in that**

- the fault location determination is only carried out if, following the occurrence of the fault, it is discerned that the fault is an unbalanced three-pole fault.

5. Apparatus (10) for identifying the fault location (F) of an unbalanced three-pole fault on a line (11) of a three-phase electrical energy supply grid, wherein

- the apparatus (10) has a measurement device (14) that is configured to measure current and voltage values of the three phases (L1, L2, L3) of the line (11) at a measurement point (M) at a line end of the line (11); and wherein
- the apparatus (10) has an evaluation unit (15) that is configured, following the occurrence of a fault on the line (11), to determine the fault location (F) of said fault using the measured current and voltage values; wherein
- the evaluation unit (15) is configured to determine a reactance of the section of the line (11) running to the fault location (F) using the measured current and voltage values either of the three conductor-to-earth fault loops or of the three conductor-to-conductor fault loops, wherein the individual fault resistance of the individual phases (L1, L2, L3) is taken into account when determining the reactance, and wherein the individual fault resistance is taken into account when determining the reactance by using a voltage correction variable that is adjusted according to the selected fault loop, and to identify the fault location (F) by comparing the reactance with the total reactance of the line (11).

**Revendications**

1. Procédé de recherche de l'emplacement (F) d'un défaut non symétrique à trois pôles sur une ligne (11) d'un réseau d'alimentation en énergie électrique triphasé, dans lequel

- on mesure, en un point (M) de mesure, à un bout de la ligne (11), des valeurs de courant et de tension des trois phases (L1, L2, L3) de la ligne (11) ; et
- en utilisant les valeurs mesurées de courant et de tension, on détermine, après l'apparition d'un défaut sur la ligne (11), son emplacement (F) ; dans lequel
- en utilisant les valeurs mesurées de courant et de tension, soit des trois boucles conducteur conducteur - terre - défaut, soit des trois boucles conducteur - conducteur - défaut, on détermine une réactance du tronçon, s'étendant jusqu'à l'emplacement (F) du défaut, de la ligne (11), dans lequel on prend en compte la résistance individuelle de défaut des diverses phases (L1, L2, L3) lors de la détermination de la réactance, dans lequel on prend en compte la résistance individuelle de défaut en utilisant une grandeur de correction de tension lors de la détermination de la réactance, qui est adaptée à la boucle de défaut sélectionnée ; et
- par comparaison de la réactance à la réactance d'ensemble de la ligne (11), on détermine l'emplacement (F) du défaut.

2. Procédé suivant la revendication 1,
**caractérisé en ce que**,

- lors de l'utilisation des valeurs de courant et de tension pour les trois boucles conducteur - terre, on utilise, comme grandeur de correction de la tension, une tension entre le point neutre du défaut et la terre.

3. Procédé suivant la revendication 1,
   **caractérisé en ce que**,

   - lors de l'utilisation des valeurs de courant et de tension pour les trois boucles conducteur - conducteur, on utilise, comme grandeur de correction de la tension, une tension de l'une des phases entre le point de mesure et le point neutre du défaut.

4. Procédé suivant l'une des revendications précédentes, **caractérisé en ce que**

   - l'on n'effectue la détermination de l'emplacement du défaut, que si l'on détecte, après l'apparition du défaut, que le défaut est un défaut non symétrique à trois pôles.

5. Dispositif (10) de recherche de l'emplacement (F) d'un défaut non symétrique à trois pôles sur une ligne (11) d'un réseau d'alimentation en énergie électrique triphasé, dans lequel

   - le dispositif (10) a un système (14) de mesure, qui est agencé pour mesurer en un point (M) de mesure, à un bout de la ligne (11), des valeurs de courant et de tension des trois phases (L1, L2, L3) de la ligne (11) ; et dans lequel
   - le dispositif (10) a une unité (15) d'analyse, qui est agencée pour, en utilisant les valeurs de courant et de tension mesurées après l'apparition d'un défaut sur la ligne (11), en déterminer l'emplacement (F) du défaut ; dans lequel
   - l'unité (15) d'analyse est agencée pour, en utilisant les valeurs de courant et de tension mesurées, soit des trois boucles conducteur - terre - défaut, soit des trois boucles conducteur - conducteur - défaut, mesurer une réactance du tronçon, s'étendant jusqu'à l'emplacement (F) du défaut, de la ligne (11), dans lequel on tient compte, à la détermination de la réactance, de la résistance de défaut individuelle des diverses phases (L1, L2, L3) et dans lequel on tient compte, à la détermination de la réactance, de la résistance de défaut individuelle en utilisant une grandeur de correction de la tension, qui est adaptée conformément à la boucle de défaut sélectionnée, et pour déterminer l'emplacement (F) du défaut par comparaison de la réactance à la réactance d'ensemble de la ligne (11).

FIG 1

## FIG 2

FIG 3

EP 3 913 382 B1

FIG 4

FIG 5

```
              ┌──────────────────────┐
              │          50          │
              └──────────┬───────────┘
                         │
                         ▼
                    ◇────────────◇
              ┌─────    51     ─────┐
            n │    ◇────────────◇    │ j
              ▼                      ▼
   ┌──────────────────┐   ┌──────────────────┐
   │        52        │   │        53        │
   └──────────────────┘   └─────────┬────────┘
                                    │
                                    ▼
                             ◇────────────◇
                       ┌─────    54     ─────┐
                     n │    ◇────────────◇    │ j
                       ▼                      ▼
            ┌──────────────────┐   ┌──────────────────┐
            │        55        │   │        57        │
            └─────────┬────────┘   └────────┬─────────┘
                      └───────────●─────────┘
                                  ▼
                       ┌──────────────────┐
                       │        56        │
                       └──────────────────┘
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2476002 B1
- WO 2012126526 A1
- US 2012086459 A1
- US 4996624 A
- US 5929642 A
- WO 2016091334 A1

**In der Beschreibung aufgeführte Nicht-Patentliteratur**

- **DAS SWAGATA et al.** Impedance-Based Fault Location in Transmission Networks: Theory and Application. *IEEE ACCESS,* 29. Mai 2014, vol. 2, 537-557